(19) Europäisches Patentamt
European Patent Office
Office européen des brevets

(11) **EP 2 036 997 A1**

(12) **EUROPEAN PATENT APPLICATION**

(43) Date of publication:
**18.03.2009 Bulletin 2009/12**

(51) Int Cl.:
*C23C 4/12* (2006.01)       *C23C 24/08* (2006.01)
*C23C 28/00* (2006.01)      *C23C 28/04* (2006.01)
*B23B 27/14* (2006.01)      *C23C 14/06* (2006.01)
*C23C 14/32* (2006.01)

(21) Application number: **08157074.9**

(22) Date of filing: **28.05.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **01.06.2007 SE 0701320**

(71) Applicant: **Sandvik Intellectual Property AB
811 81 Sandviken (SE)**

(72) Inventors:
• **Pettersson, Marie
SE-125 40, Älsvsjö (SE)**

• **Lundquist, Anders
SE 136 59, Haninge (SE)**
• **Norgren, Susanne
SE-141 41, Huddinge (SE)**
• **Myrtveit, Toril
SE 196 30, Kungsängen (SE)**
• **Sundström, Rickard
SE-138 36, Älta (SE)**

(74) Representative: **Hägglöf, Henrik
Sandvik Intellectual Property AB
811 81 Sandviken (SE)**

(54) **Coated cemented carbide cutting tool inserts**

(57)    The present invention relates to PVD coated cemented carbide cutting tool inserts roughing to finishing milling operations. The cemented carbide cutting tool insert comprises a substrate and a wear resistant coating. The substrate comprises in addition to WC, 5.5-8.5 wt-% Co and Cr such that the Cr/Co weight ratio is 0.08-0.12 and also small amounts of Ti and Ta. The wear resistant coating is a homogeneous $Al_xTi_{1-x}N$-layer with x=0.6-0.67. The thickness of this layer is 1.2-3.6 $\mu$m.

EP 2 036 997 A1

**Description**

The present invention relates to a coated cemented carbide cutting tool insert. More specifically the invention relates to PVD coated cemented carbide cutting tool inserts from roughing to finishing in metal cutting operations.

High performance cutting tools must possess high wear resistance, high toughness properties and good resistance to plastic deformation. This is particularly valid when the cutting operation is carried out at high cutting speeds and/or at high feed rates when large amount of heat is generated.

Cemented carbide grades for metal machining applications generally contain WC, γ-phase, which is a solid solution of generally TiC, NbC, TaC and WC, and binder phase, generally Co and/or Ni. WC-Co cemented carbides having a fine grain size <1 $\mu$m are produced through the incorporation of grain growth inhibitors such as V, Cr, Ti, Ta and combinations thereof in the initial powder blend. Typical inhibitor additions are 0.5 to 5 wt-% of the binder phase.

It is an object of the present invention to provide inserts with a coated cemented carbide with improved wear resistance without sacrificing toughness and edge security, particularly useful for roughing to finishing operations of metal materials.

This object is solved by providing a cemented carbide insert consisting of a WC+Co-substrate with fine grain size provided with a PVD coating.

According to the present invention there is provided coated cemented carbide shaped inserts for roughing to finishing machining of metals, comprising a cemented carbide substrate, a wear resistant coating, and different insert geometries. The substrate comprises in addition to WC 5.5-8.5, preferably 6-8, wt-% Co and Cr such that the Cr/Co weight ratio is 0.08-0.12, preferably 0.09-0.11. The substrate also contains Ti and Ta in such amounts that the ratio

$$Me/Co=(at\%Ti+at\%Ta)/at\%Co$$

is less than or equal to 0.014-(CW-Cr)*0.008 and higher than 0.0005 preferably higher than 0.0007 and CW-Cr is 0.75-0.95, preferably 0.78-0.93, where

$$CW-Cr= (magnetic-\% \ Co \ +1.13*wt-\%Cr)/wt-\%Co$$

where magnetic-% Co is the weight percentage of magnetic Co and wt-% Co is the weight percentage of Co in the cemented carbide. The CW-Cr is a function of the W content in the Co binder phase. A CW-Cr of about 1 corresponds to a low W-content in the binder phase and a CW-Cr of 0.75-0.93, preferably 0.8.-0.88 corresponds to a high W-content in the binder phase.

The coercivity is >20 kA/m, preferably 23-31 kA/m, most preferably 26-29.The sintered body may also contain small amounts of precipitations of additional phase or phases such as eta-phase, MX or $M_7X_3$, $M_3X_2$ where M= (Ti+Ta+Co+Cr+W) and X=C or N maybe allowed to a volume fraction of maximum 5.0 vol% without detrimental effects.

The wear resistant coating comprises a homogeneous $Al_xTi_{1-x}N$-layer with x=0.6-0.67, preferably x=0.63-0.64 as measured by EDS on the flank side 0.2 mm below the cutting edge and 1mm from the nose. The thickness of the layer is >1.2 $\mu$m, preferably >1.5 $\mu$m but <3.6 $\mu$m, preferably <3.3 $\mu$m. The coating thickness is measured on a polished cross section performed on the flank side of the insert 0.2 mm below the nose radius, 1 mm from the nose.

The present invention also relates to a method of making cemented carbide cutting tool inserts for roughing to finishing operations in milling applications, comprising the following steps providing a cemented carbide substrate with a composition according to above by:

- wet milling submicron powders of tungsten carbide, cobalt, Ti and Ta added as TiC, TaC, (Ti,W)C, (Ta,W)C or (Ti, Ta,W)C and at least one of $Cr_3C_2$, $Cr_{23}C_6$ and $Cr_7C_3$ to obtain a slurry,
- drying the slurry to obtain a powder,
- pressing the powder to inserts,
- sintering the inserts in vacuum,
- possibly performing an isostatic gas pressure step during sintering temperature or at the final stage of sintering
- possibly grinding the inserts to desired shapes
- depositing by arc evaporation technique whilst maintaining a partial pressure of nitrogen in the recipient, and using the appropriate selection of active evaporation sources and -rates
- a wear resistant coating comprising a homogeneous $Al_xTi_{1-x}N$-layer with x=0.6-0.67, preferably x=0.63-0.64. The thickness of the layer is >1.2 $\mu$m, preferably >1.5 $\mu$m but <3.6 $\mu$m, preferably <3.3 $\mu$m, the composition and the thickness being measured on the flank face 0.2 mm below the nose radius and 1mm from the nose.

In a first embodiment the present invention relates to the use of inserts according to above for milling applications in harder steels and hardened steels in roughing to finishing operations in work pieces with a hardness of 36-65 HRC, for such as die and mould.

- at cutting speeds of 40 - 200 m/min, feed rates of 0.05 - 0.3 mm/rev and depth of cut of 0.02 - 3 mm in milling applications

In a second embodiment the present invention relates to the use of inserts according to above for machining in cast iron application in finishing operations.

- at cutting speeds of 250 - 1200 m/min, tooth feed of 0.05 - 0.2 mm/tooth and axial depth of cut of 0.15 - 1 mm in milling application.

Example 1

Tungsten carbide powder, 7 wt% very fine grained cobalt powder and 0.7 wt-% Cr added as H.C.Starck fine grained $Cr_3C_2$-powder, 0.014 wt-% Ti and 0.010 wt-% Ta, added as TiC and TaC, were wet milled together with conventional pressing agents. After milling and spray drying the powder was pressed to shape blanks for inserts and sintered at 1410 °C. The sintered material had a coercivity of 27 kA/m corresponding to a WC grain size of about 0.8-0.9 $\mu$m. Substrate data are summarised in the table below.

| | Ti, wt-% | Ta, wt-% | Me/Co | Co, wt-% | Cr, wt-% | Cr/ Co | CW-Cr | 0.014-(CW-Cr)*0.008 |
|---|---|---|---|---|---|---|---|---|
| Substrate data | 0.014 | 0.010 | 0.0029 | 7.00 | 0.70 | 0.10 | 0.85 | 0.0062 |

The inserts were wet cleaned. A homogeneous (Ti,Al)N layer was deposited by cathodic arc evaporation using a target material consisting of a $Ti_{0.33}Al_{0.67}$ alloy in an $N_2$ gas atmosphere. The thickness of the layer was 2.5 $\mu$m and it consisted of a homogeneous layer with the composition $Al_{0.63}Ti_{0.37}N$ as determined by EDS-analysis, using a SEM Hitachi S-4300, Oxford Instrument Link INCA.

Example 2.

Inserts from Example 1 were tested and compared with inserts of a commercially available market reference (grade, coating, shape) for the intended application area. The test represents the upper range in terms of work piece hardness

| | |
|---|---|
| Operation: | Profiling, Coromill 216 |
| Work-piece: | mould |
| Material: | Cold work steel, 62 HRC |
| Cutting speed: | 72 m/min |
| Feed rate/tooth: | 0.235 mm/tooth |
| Axial depth of cut: | 3.0 mm |
| Radial depth of cut: | 1.5 mm |
| Insert-style: | R216-3006M-M |
| Cutter diameter: | 30 mm |

Note: two insert in the cutter, dry machining.

Tool-life criterion was edgeline toughness and chipping.
A combination of better edge line security and better wear resistance gave a considerable increase in tool life.

| Results: | Tool-life, minutes in cut |
|---|---|
| Prior art B: | 25 |
| Invention A: | 45 |

Example 3.

Inserts from Example 1 were tested and compared with inserts of a commercially available market reference (grade, coating, shape) for the intended application area. The test represents the upper range in terms of work piece hardness

| Operation: | Face milling, Coromill 245 |
|---|---|
| Work-piece: | cylinder |
| Material: | Highly alloyed steel, 16MnCrS5, 62 HRC |
| Cutting speed: | 40 m/min |
| Feed rate/tooth: | 0.10 mm/tooth |
| Axial depth of cut: | 2.0 mm |
| Radial depth of cut: | 50 mm |
| Insert-style: | R245-12T3E-PL |
| Cutter diameter: | 63 mm |
| Note: 5 insert in the cutter, dry machining. | |

Tool-life criterion was flank wear and edgeline toughness
A combination of better comb crack resistance leading to good edge line security and gave a considerable increase in tool life.

| Results: | Tool-life, minutes in cut |
|---|---|
| Prior art B: | 50 min |
| Invention A: | 120 min |

Example 4.

Inserts from Example 1 were tested and compared with inserts of a commercially available market reference for the intended application area. The test represents finishing in ISO-K area

| Operation: | Face milling, Coromill 390 |
|---|---|
| Work-piece: | cylinder |
| Material: | SS0125, Grey cast iron |
| Cutting speed: | 1093 m/min |
| Feed rate/tooth: | 0.07 mm/tooth |
| Axial depth of cut: | 0.2 mm |
| Radial depth of cut: | 30 mm |
| Insert-style: | R390-11T308M-PL |
| Cutter diameter: | 40 mm |
| Note: 6 insert in the cutter, dry machining. | |

Tool-life criterion was flank wear leading to bad surface finish.
A better wear resistance gave a considerable increase in tool life.

| Results: | Tool-life, minutes in cut |
|---|---|
| Prior art B: | 165 min |
| Invention A: | 500 min |

Example 5.

Inserts from Example 1 were tested and compared with GC1030 reference. The test represents the middle area of hardness.

| Operation: | Face milling, Coromill 300 |
| --- | --- |
| Work-piece: | Forging die |
| Material: | W. no: 1.2343, 53 HRC |
| Cutting speed: | 90 m/min |
| Feed rate/tooth: | 0.40 mm/tooth |
| Axial depth of | cut: 0.40 mm |
| Radial depth of cut: | 25 mm |
| Insert-style: | R300-1240M-PH |
| Cutter diameter: | 40 mm |
| Note: 4 insert in the cutter, dry machining. | |

Tool-life criterion was resistance to plastic deformation and flank wear.

A better resistance to plastic deformation and better wear resistance gave a considerable increase in tool life. The application area is not for the intended Reference B.

| Results: | Tool-life, minutes in cut |
| --- | --- |
| Reference B: | 4 min |
| Invention A: | 42 min |

Example 6.

Inserts from Example 1 were tested and compared with inserts of a commercially available market reference (grade, coating, shape) for the intended application area. The test represents the upper range in terms of work piece hardness.

| Operation: | High finishing profiling, Coromill 216F |
| --- | --- |
| Work-piece: | Test work piece |
| Material: | W.no: 1.2379, 63 HRC |
| Cutting speed: | 110 m/min |
| Feed rate/tooth: | 0.235 mm/tooth |
| Axial depth of cut: | 0.20 mm |
| Radial depth of cut: | 0.20 mm |
| Insert-style: | R216F-1640E-L |
| Cutter diameter: | 16 mm |
| Note: 1 insert in the cutter, dry machining. | |

Tool-life criterion was flank wear

A better wear resistance gave a considerable increase in tool life.

| Results: | Tool-life, minutes in cut |
| --- | --- |
| Prior art B: | 675 min |
| Invention A: | 840 min |

**Claims**

1. Cemented carbide cutting tool insert for roughing to finishing metal cutting operations, comprising a substrate and a wear resistant coating, of different shapes
**characterized in that**

- the substrate comprises in addition to WC, 5.5-8.5, preferably 6-8, wt- % Co and Cr such that the Cr/Co weight ratio is 0.08-0.12, preferably 0.09-0.11, and also Ti and Ta in such amounts that the ratio of Me/Co= (at%Ti+at%Ta) /at%Co is less than or equal to 0.014-(CW- Cr) *0.008 and higher than 0.0005 preferably higher than 0.0007 and the CW- Cr of 0.75-0.93, preferably 0.8.- 0.88

$$\texttt{CW-Cr= (magnetic-\% Co +1.13*wt-\%Cr)/wt-\%Co}$$

where magnetic-% Co is the weight percentage of magnetic Co and wt-% Co is the weight percentage of Co in the cemented carbide and the coercivity is >20 kA/m, preferably 23-31 kA/m, most preferably 26-29 and the wear resistant coating is a homogeneous $Al_xTi_{1-x}N$-layer with x=0.6-0.67, preferably x=0.63-0.64 as measured by EDS on the flank side 0.2mm below the cutting edge and 1mm from the nose, with thickness of >1.2 $\mu$m, preferably >1.5 $\mu$m but <3.6 $\mu$m, preferably <3.3 $\mu$m, the coating thickness being measured on the flank face 1 mm from the nose and 0.2 mm below the nose radius.

2. Method of making a cemented carbide cutting tool insert for roughing to finishing metal cutting operations, comprising a substrate, a wear resistant coating and different shapes **characterized in** the following steps

- providing a substrate comprising in addition to WC, 5.5-8.5, preferably 6-8, wt- % Co and Cr such that the Cr/Co weight ratio is 0.08-0.12 and also Ti and Ta in such amounts that the ratio of Me/Co= (at%Ti+at%Ta) /at%Co is less than or equal to 0.014-(CW- Cr) *0.008 and higher than 0.0005 preferably higher than 0.0007 and the CW- Cr is 0.75-0.93, preferably 0.8.- 0.88 whereby the CW- Cr is defined as

$$\texttt{CW-Cr= (magnetic-\% Co +1.13*wt-\%Cr)/wt-\%Co}$$

where magnetic-% Co is the weight percentage of magnetic Co and wt-% Co is the weight percentage of Co in the cemented carbide and the coercivity is >20 kA/m, preferably 23-31 kA/m, most preferably 26-29

- wet milling submicron powders of tungsten carbide, cobalt, Ti and Ta added as TiC, TaC, (Ti,W)C, (Ta,W)C or (Ti,Ta,W)C and at least one of $Cr_3C_2$, $Cr_{23}C_6$ and $Cr_7C_3$ to obtain a slurry,
- drying the slurry to obtain a powder,
- pressing the powder to inserts,
- sintering the inserts in vacuum, and
- possibly performing an isostatic gas pressure step during sintering temperature or at the final stage of sintering
- possibly grinding the inserts to requested shapes
- depositing by arc evaporation technique whilst maintaining a partial pressure of nitrogen in the recipient, and using the appropriate selection of active evaporation sources and -rates a wear resistant coating comprising a homogeneous $Al_xTi_{1-x}N$-layer with x=0.6-0.67, preferably x=0.63-0.64 as measured by EDS on the flank side 0.2mm below the cutting edge and 1mm from the nose, with thickness of >1.2 $\mu$m, preferably >1.5 $\mu$m but <3.6 $\mu$m, preferably <3.3 $\mu$m, thickness being measured on the flank face 0.2 mm below the nose radius 1 mm from the nose

3. Use of an insert according to claim 1 for roughing to finishing operations in milling applications of work pieces with a hardness of 30-65 HRC.

4. Use of an insert according to claim 1 for machining in cast iron application in finishing operations at cutting speeds of 250 - 1200 m/min, tooth feed of 0.05 - 0.2 mm/tooth and axial depth of cut of 0.15 - 1 mm in milling application.

Europäisches
Patentamt

European
Patent Office

Office européen
des brevets

## EUROPEAN SEARCH REPORT

Application Number

EP 08 15 7074

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 526 189 A (SANDVIK AB [SE]) 27 April 2005 (2005-04-27) * example 1 * ----- | 1-4 | INV. C23C4/12 C23C24/08 C23C28/00 |
| A | EP 1 548 136 A (SANDVIK AB [SE] SANDVIK INTELLECTUAL PROPERTY [SE]) 29 June 2005 (2005-06-29) * claims 1-11; examples 1-8 * ----- | 1-4 | C23C28/04 B23B27/14 C23C14/06 C23C14/32 |
| A | WO 97/20082 A (SANDVIK AB [SE]; LINDSKOG PER [SE]; GUSTAFSON PER [SE]; LJUNGBERG BJOE) 5 June 1997 (1997-06-05) * example 1 * ----- | 1-4 | |
| A | US 2002/050102 A1 (LENANDER ANDERS [SE] ET AL) 2 May 2002 (2002-05-02) * claims 1-23 * ----- | 1-4 | |
| A | EP 1 795 628 A (SANDVIK INTELLECTUAL PROPERTY [SE]) 13 June 2007 (2007-06-13) * paragraph [0012]; claims 1-6 * ----- | 1-4 | |

TECHNICAL FIELDS
SEARCHED      (IPC)

B23B
C22C
C23C

The present search report has been drawn up for all claims

| Place of search | Date of completion of the search | Examiner |
|---|---|---|
| Munich | 13 November 2008 | Badcock, Gordon |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 15 7074

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2008

| Patent document cited in search report | | Publication date | Patent family member(s) | | Publication date |
|---|---|---|---|---|---|
| EP 1526189 | A | 27-04-2005 | JP | 2005126824 A | 19-05-2005 |
| | | | KR | 20050039617 A | 29-04-2005 |
| | | | SE | 527348 C2 | 14-02-2006 |
| | | | SE | 0302783 A | 24-04-2005 |
| | | | US | 2007196694 A1 | 23-08-2007 |
| | | | US | 2005126336 A1 | 16-06-2005 |
| EP 1548136 | A | 29-06-2005 | AT | 389737 T | 15-04-2008 |
| | | | CN | 1636654 A | 13-07-2005 |
| | | | ES | 2301959 T3 | 01-07-2008 |
| | | | JP | 2005177981 A | 07-07-2005 |
| | | | KR | 20050060024 A | 21-06-2005 |
| | | | US | 2005129951 A1 | 16-06-2005 |
| WO 9720082 | A | 05-06-1997 | AT | 213283 T | 15-02-2002 |
| | | | BR | 9611781 A | 23-02-1999 |
| | | | CN | 1203637 A | 30-12-1998 |
| | | | DE | 69619275 D1 | 21-03-2002 |
| | | | DE | 69619275 T2 | 24-06-2004 |
| | | | EP | 0874919 A1 | 04-11-1998 |
| | | | IL | 124475 A | 26-08-2001 |
| | | | JP | 2000515588 T | 21-11-2000 |
| | | | US | 6200671 B1 | 13-03-2001 |
| | | | US | RE39999 E1 | 08-01-2008 |
| US 2002050102 | A1 | 02-05-2002 | NONE | | |
| EP 1795628 | A | 13-06-2007 | CN | 1978192 A | 13-06-2007 |
| | | | JP | 2007196365 A | 09-08-2007 |
| | | | KR | 20070061456 A | 13-06-2007 |
| | | | SE | 0502694 A | 09-06-2007 |
| | | | US | 2007141346 A1 | 21-06-2007 |

EPO FORM P0459

For more details about this annex : see Official Journal of the European Patent Office, No. 12/82